(19) Europäisches Patentamt
European Patent Office
Office européen des brevets

(11) Veröffentlichungsnummer: **0 019 896**
**B1**

# (12) EUROPÄISCHE PATENTSCHRIFT

(45) Veröffentlichungstag der Patentschrift: **02.10.85**

(51) Int. Cl.[4]: **G 03 F 3/10,** G 03 F 7/08

(21) Anmeldenummer: **80102931.5**

(22) Anmeldetag: **27.05.80**

(54) **Farbprüffolie.**

(30) Priorität: **01.06.79 US 45468**

(43) Veröffentlichungstag der Anmeldung: **10.12.80 Patentblatt 80/25**

(45) Bekanntmachung des Hinweises auf die Patenterteilung: **02.10.85 Patentblatt 85/40**

(84) Benannte Vertragsstaaten: **BE DE FR GB IT NL**

(56) Entgegenhaltungen:
**DE-A-2 522 784**
**FR-A-2 137 857**
**GB-A-1 009 187**
**GB-A-1 440 281**
**US-A-3 004 056**
**US-A-3 264 108**
**US-A-4 157 918**

**PRODUCT LICENSING INDEX RESEARCH DISCLOSURE, Nr. 84, April 1971, Industrial Opportunities, Homewell, Havant, Hampshire, GB, "Photographic transfer elements and processes for preparing and using them", Seiten 21-25**

(73) Patentinhaber: **AMERICAN HOECHST CORPORATION, Route 202-206 North, Somerville, N.J. 08876 (US)**

(72) Erfinder: **Liu, Shuchen, 59 North Slope, Clinton New Jersey 08809 (US)**

(74) Vertreter: **Euler, Kurt Emil, Dr. et al, KALLE Niederlassung der Hoechst AG Rheingaustrasse 190 Postfach 3540, D-6200 Wiesbaden 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



BUNDESDRUCKEREI BERLIN

**Beschreibung**

Die Erfindung betrifft Farbprüffolien sowie Verfahren und Materialien zur Herstellung von dunkelfarbenen Farbprüffolien mit Hilfe lichtempfindlicher Materialien erhöhter Lichtempfindlichkeit.

Nach der Lehre der US-PS 3 326 682 lassen sich positiv arbeitende Farbprüffolien durch Beschichten eines transparenten Trägers, vorzugsweise aus Polyethylenglykolterephthalat, mit o-Chinondiaziden und farbgebenden Mitteln und ggf. Harzen und anderen Zusätzen herstellen. Bei der praktischen Anwendung dieses Verfahrens werden von positiven Silberhalogenid-Farbauszügen, die als Belichtungsmasken für die entsprechend gefärbten Prüffolien verwendet werden, ausgezeichnete Materialien für die Farbprüfung durch Übereinanderlegen von Teilfarbenbildern erhalten. Nach dem Belichten und Entwickeln in verdünntem wäßrigem Alkali können die Folien einzeln betrachtet und dann übereinander auf eine weiße reflektierende Unterlage gelegt werden, so daß man sich im voraus ein Bild von dem Druck machen kann, der von Platten gedruckt werden soll, die man von den positiven Silberhalogenid-Farbauszügen herstellen will.

Gewöhnlich wird eine schwarzbeschichtete Folie mitverwendet, um auf diese Weise zusätzliche Farbtiefe über die Farbtiefe hinaus zu erreichen, die man mit den drei Teilfarbenbildern aus Blaugrün, Purpur und Gelb erzielt. Die Erfahrung hat gelehrt, daß der Zusatz eines schwarzen Farbstoffs oder Pigments zu dem Beschichtungsgemisch der Folie, bedingt durch die Lichtabsorption des schwarzen Farbstoffs oder Pigments, zu einer erheblichen Verlängerung der erforderlichen Belichtungszeit führt. Dunkle Folien in anderen dunklen Farbtönen erfordern gleichfalls eine in unerwünschter Weise verlängerte Belichtungszeit.

Bei Schwarz hat man beispielsweise versucht, die Belichtungszeit durch Reduzieren der Menge an schwarzem Farbstoff oder Pigment zu verkürzen. Das hat aber den unerwünschten Effekt, daß sich ein Mittelgrau oder Hellgrau anstelle des bevorzugten intensiven Tiefschwarz ergibt. Das gleiche gilt auch für andere dunkle Farbtöne, die außer bei den Mehrfarbenverfahren auch in der graphischen Technik für andere Zwecke verwendet werden können.

Ein weiterer Versuch, die durch die volle Menge an schwarzem Farbstoff oder Pigment bewirkte Verlängerung der Belichtungszeit auszuschalten, ist in der US-PS 4 154 613 beschrieben. Gemäß dieser Erfindung hat man festgestellt, daß eine Gesamtbelichtung ohne Vorlage vor oder nach dem bildmäßigen Belichten selbst dann zu einer höchst wünschenswerten Verkürzung der bildmäßigen Belichtung führt, wenn der Farbstoff oder das Pigment in der für intensive, satte Farbtöne erforderlichen Menge in der Beschichtung enthalten ist. Hierfür benötigt man jedoch eine besondere Vorrichtung und einen zusätzlichen Verfahrensschritt.

Die Einführung automatischer Belichtungs- und Entwicklungsvorrichtungen stellt eine neue Entwicklung auf dem Gebiet der Farbprüftechnik dar. Wenn solche Vorrichtungen eingesetzt werden, sollten die Folien aller Farbtöne, ganz gleich, ob sie dunkel oder hell eingefärbt sind, die gleiche Lichtempfindlichkeit und das gleiche Entwicklungsverhalten aufweisen, damit sie nicht einzeln von Hand bearbeitet zu werden brauchen. Abgesehen von der obengenannten Methode des Vor- oder Nachbelichtens der Folie ohne Vorlage hat es bisher kein geeignetes Verfahren zur Angleichung der Lichtempfindlichkeit der verschiedenen unterschiedlich gefärbten Prüffolien gegeben.

Aus der GB-A 1 009 187 ist ein photographisches Silberhalogenidmaterial auf Gelatinebasis bekannt, das als Weichmacher für die Gelatineschicht Ester der Phosphorsäure mit Polyoxyalkylenmonoethern enthält.

In der US-A 3 264 108 werden Silberhalogenidmaterialien beschrieben, die entsprechende Phosphorsäureester zur antistatischen Ausrüstung der lichtempfindlichen Schicht enthalten.

Aus der DE-A 2 522 784 sind lichtempfindliche Druckplatten bekannt, deren lichtempfindliche Schicht Bindemittel, lichtempfindliche Verbindungen, wie Diazoniumsalz-Kondensationsprodukte oder o-Chinondiazide, und bestimmte Netzmittel, z. B. anionische oberflächenaktive Mittel mit Phosphorsäure- oder Phosphorsäureestergruppen, enthalten, um das Aufziehen des Bindemittels und das Entfernen des Bindemittels beim Entwickeln zu erleichtern und ferner der Platte gute Druckeigenschaften zu verleihen.

Aufgabe der Erfindung ist es daher, Verfahren und Materialien zur Herstellung von Farbprüffolien mit erhöhter Lichtempfindlichkeit vorzuschlagen, welche die bisherigen Nachteile nicht mehr haben.

Die Erfindung schlägt ein lichtempfindliches Material für die Herstellung einer Farbprüffolie mit erhöhter Empfindlichkeit gegen aktinisches Licht vor, das aus einer im wesentlichen transparenten polymeren Trägerfolie, auf deren Oberfläche eine dünne Schicht eines lichtempfindlichen Gemisches haftet, das als wesentliche Bestandteile

a) ein farbgebendes Mittel,
b) als lichtempfindliche Substanz ein Iminochinondiazid, ein p-Chinondiazid, ein Kondensationsprodukt einer aromatischen Diazoniumverbindung, ein o-Chinondiazid oder ein Gemisch aus einer bei Bestrahlung Säure abspaltenden Verbindung und einer Verbindung mit mindestens einer Orthocarbonsäureestergruppe oder einer Carbonsäureamidacetalgruppe und
c) ein anionisches Netzmittel enthält.

Das erfindungsgemäße Material ist dadurch gekennzeichnet, daß das Netzmittel das Reaktionsprodukt von 1 Mol $P_2O_5$ mit 2 bis 4,5 Mol eines Kondensationsproduktes aus mindestens 1 Mol Alkylenoxid mit 2 bis 4 C-Atomen und 1 Mol einer Verbindung mit 6 bis 150 C-Atomen ist, die ein reaktives Wasserstoffatom enthält und ein Phenol, Alkylphenol, aliphatischer Alkohol, eine Fettsäure, ein Fettamin, Fettsäureamid, Kolophoniumamin, langkettiges Sulfonsäureamid, mit langkettigen Alkylgruppen substituiertes Arylsulfonsäureamid oder hochmolekulares Mercaptan sein kann, wobei dieses Reaktionsprodukt unter im wesentlichen wasserfreien Bedingungen bei einer Temperatur zwischen Raumtemperatur und etwa 110° C hergestellt wird.

Das anionische Netzmittel erhält man durch Reaktion von $P_2O_5$ mit einem Kondensationsprodukt aus einem Alkylenoxid und einer organischen Verbindung, die reaktiven Wasserstoff enthält. Die erfindungsgemäßen lichtempfindlichen Materialien haben eine stark erhöhte Lichtempfindlichkeit, und ihre lichtempfindlichen Schichten weisen dabei die erforderliche gute Haftung auf den Trägerfolien, eine gute Kratzbeständigkeit, Klebefreiheit und eine annehmbare Entwicklerresistenz auf.

Mit Ausnahme des anionischen Netzmittels können die Bestandteile der lichtempfindlichen Beschichtungsgemische die üblichen Bestandteile sein, die für derartige Gemische in positiv und negativ arbeitenden lichtempfindlichen Systemen bekannt sind. Es ist wichtig, solche Netzmittel zu wählen, die mit den Komponenten sowohl der Beschichtungslösung als auch der endgültigen trockenen Schicht verträglich sind, damit die Bildbereiche auf der Prüffolie möglichst transparent sind und die Farbwerte nicht durch Unverträglichkeiten beeinträchtigt werden.

Bei schwarzen und sehr dunklen Farbtönen kommt es zu der stärksten Verkürzung der Belichtungszeit im Vergleich zu bekannten Beschichtungsgemischen, d. h. durch den Zusatz der genannten anionischen Netzmittel zu den Gemischen erzielt man gerade bei diesen dunklen Farbtönen die größte Zunahme an Lichtempfindlichkeit.

Die erfindungsgemäß verwendeten anionischen Netzmittel sind organische Phosphorsäureester nichtionischer Netzmittel und bestehen aus den Reaktionsprodukten von etwa 1 Mol $P_2O_5$ mit etwa 2 bis 4,5 Mol eines Kondensationsprodukts aus mindestens etwa 1 Mol eines Alkylenoxids mit 2 bis 4 C-Atomen und 1 Mol einer Verbindungg mit etwa 6 bis 150 C-Atomen, die ein reaktives Wasserstoffatom aufweist und ein Phenol, Alkylphenol, aliphatischer Alkohol, eine Fettsäure, ein Fettamin, Fettsäureamid, Kolophoniumamin, langkettiges Alkylsulfonsäureamid, mit langkettigen Alkylgruppen substituiertes Arylsulfonsäureamid oder ein hochmolekulares Mercaptan sein kann, wobei diese Reaktionsprodukte unter im wesentlichen wasserfreien Bedingungen bei einer Temperatur zwischen Raumtemperatur und etwa 110° C hergestellt werden.

Für die Reaktion mit $P_2O_5$ werden solche nichtionischen Netzmittel bevorzugt, welche die Kondensationsprodukte von Ethylenoxid mit den obengenannten, ein aktives Wasserstoffatom enthaltenden organischen Verbindungen sind. Anionische Netzmittel des beschriebenen Typs sind in der US-PS 3 004 056 offenbart.

Insbesondere bevorzugte anionische Netzmittel nach dieser Erfindung entsprechen mindestens einer Verbindung gemäß einer der nachfolgenden Formeln I oder II

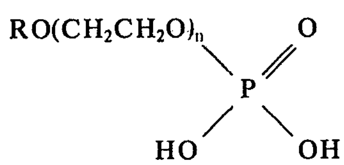

(I)

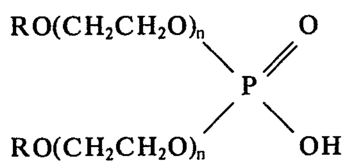

(II)

worin R eine Alkyl- oder Arylgruppe ist und n die mittlere Molzahl an Oxyethyleneinheiten, die im Bereich von 1 bis 32 liegt.

Die oben beschriebenen anionischen Netzmittel sind im Handel erhältlich. Diese Substanzen sind in erster Linie Flüssigkeiten, einige haben jedoch auch die Konsistenz von wachsartigen Pasten. Sie enthalten 89 bis 100% aktive Substanz. Ihr spezifisches Gewicht reicht von etwa 1,00 bis ungefähr 1,25. Sie haben Fließpunkte nach ASTM zwischen unterhalb 0° C und etwa 30° C, und ihre Säurezahlen, bestimmt als mg KOH je g des Produkts bis zum ersten Umschlagspunkt, liegen im Bereich von etwa 30 bis 400.

Anionische Netzmittel dieser Art sind in einer im Jahre 1976 von der GAF Corporation herausgegebenen Broschüre mit dem Titel »Gafac® Anionic Surfactants« 9643-018-3M-66) beschrieben.

Weitere im Handel erhältliche anionische Netzmittel nach der obigen Beschreibung werden von der Finetex, Inc. angeboten. Sie sind in Technischen Datenblättern mit den Titeln »Findet® SB«, »Findet® OJ-P« und Findet® GC« beschrieben. Dabei sind nur die Verbindungen mit freien Säuregruppen

wirksam.

Die Netzmittel haben eine sehr unterschiedliche Aktivität. Generell können sie in einer Konzentration von etwa 0,5 bis 60 Gew.-% in der Schicht vorliegen. Einige werden bereits bei geringen Konzentrationen aktiv, und bei ihnen müssen zu hohe Konzentrationen gegebenenfalls vermieden werden, da man festgestellt hat, daß das Bild in diesen Fällen beim Entwickeln angegriffen oder sogar gelöscht wird. Im Gegensatz dazu können bei weniger aktiven Netzmitteln auch höhere Konzentrationen erforderlich sein. Das bedeutet, daß es für jedes Netzmittel einen Optimalbereich gibt, den der Fachmann leicht ermitteln kann. Bei positiv arbeitenden Schichten werden allgemein Mengenanteile von mindestens 10 Gew.-% bevorzugt. Besonders bevorzugte Netzmittel sind Gafac® RE-610, RE-870, PE-510, RA-600 und GAFSTAT® AS-710. Die kennzeichnenden Merkmale dieser Netzmittel sind in der Tabelle im Anschluß an Beispiel 13 aufgeführt.

Das Beschichtungsgemisch kann Bindemittel, Weichmacher, Aktivatoren und andere übliche Zusätze enthalten; solche Zusätze sind jedoch bei positiv arbeitenden Gemischen normalerweise nicht erforderlich.

Geeignete Bindemittel für negativ arbeitende Schichten sind beispielsweise Celluloseester, wie Celluloseacetat, Celluloseacetatsuccinat und Celluloseacetatbutyrat; Polyvinylacetale, wie Polyvinylbutyral und Polyvinylformal; Polyamidharze; Copolymerisate von Vinylchlorid mit polaren Monomeren, wie Acrylnitril, Acryl- oder Methacrylsäure oder deren Ester, und mit Vinylacetat; polymere Ester, wie Polyvinylacetat oder Copolymerisate von Vinylacetat mit Acrylsäure, Methacrylsäure und deren Estern oder mit Maleinsäure oder Maleinsäureanhydrid; Copolymerisate von Styrol mit Comonomeren, wie Ethylacrylat, Vinylacetat und Maleinsäureanhydrid; natürliche Polymere, wie Gelatine, Casein oder Fischleim; Polyvinylalkohol, Polyacrylamide und dergleichen. Bei negativ arbeitenden Materialien hat der erfindungsgemäße Zusatz von Netzmitteln vor allem die Wirkung, daß die Entwicklungszeit verkürzt wird.

Bei einem positiv arbeitenden Gemisch können die Bindemittel alkalilösliche Harze, z. B. Phenol-Formaldehyd-Novolake und ähnliche Stoffe sein; es können jedoch auch Styrol-Maleinsäureanhydrid-Copolymerisate verwendet werden, ebenso alkalilösliche Acrylpolymerisate.

Zu den in dieser Erfindung verwendeten farbgebenden Mitteln gehören die bekannten Farbstoffe und Pigmente, deren Farbtöne im wesentlichen mit den Standardfarbtönen der für die Farbprüfung benötigten Druckfarben übereinstimmen, zum Beispiel gelb, blaugrün, purpur und schwarz. Geeignete Farbstoffe sind u. a. Grasolechtgelb 5 GL (C. I. Solvent Yellow 27), Grasolechtrubin 2 BL (C. I. Solvent Red 128), Victoriareinblau FGA (C. I. Basic Blue 81), Neozapongelb GG (C. I. Solvent Yellow 79), Neozaponechtrot BE (C. I. Solvent Red 122), Sudanblau II (C. I. Solvent Blue 35 — C. I. 61554 (S)), Victoriablau F6G (C. I. 42025), Rhodamin FB (C. I. 45170), Rhodamin 6GDN extra (C. I. 45160), Auraminkonzentrat (C. I. 41000), Ruß und ähnliche Stoffe.

Weitere geeignete Farbstoffe sind Orasolgelb 3GLG (Ciba-Geigy), Orasolschwarz, C. I. Solvent Yellow 48, C. I. Solvent Black 29, C. I. Basic Violet 10, C. I. Basic Red 1, C. I. Basic Blue 81.

Für die Zwecke dieser Erfindung geeignete lichtempfindliche Gemische bestehen aus Iminochinondiaziden, p-Chinondiaziden, o-Chinondiaziden und Kondensationsprodukten aromatischer Diazoniumverbindungen und, wenn erforderlich, geeigneten Bindemitteln. Solche Gemische sind z. B. in den US-PS 3 175 906, 3 046 118, 2 063 631, 2 667 415 und 3 867 147 beschrieben, wobei die in der letztgenannten Patentschrift beschriebenen Gemische für Negativschichten im allgemeinen bevorzugt werden.

Als positiv arbeitende lichtempfindliche Schichten werden im allgemeinen solche auf Basis von o-Chinondiaziden bevorzugt, wobei erfindungsgemäß allgemein positiv arbeitende Schichten gegenüber negativ arbeitenden bevorzugt werden.

Weitere geeignete positiv arbeitende lichtempfindliche Gemische sind in der US-PS 4 101 323 beschrieben. Dabei handelt es sich um Gemische, die eine bei Bestrahlung Säure abspaltende Verbindung (1) und eine Verbindung (2) mit mindestens einer Orthocarbonsäureestergruppe oder einer Carbonsäureamidacetalgruppe enthalten.

Es ist darauf hinzuweisen, daß alle Sensibilisatoren, farbgebenden Mittel, gegebenenfalls zugesetzten Bindemittel, Trägermaterialien und Beschichtungstechniken bei der Herstellung von Farbprüffolien zum Stand der Technik gehören.

Das lichtempfindliche Gemisch mit dem darin enthaltenden anionischen Netzmittel wird am besten so auf den Folienträger aufgebracht, daß in einem geeigneten Lösungsmittel eine Lösung oder Dispersion der Beschichtungsbestandteile hergestellt und die gewünschte Lösungsmenge nach einem geeigneten Verfahren, z. B. durch Walzen, Tauchen, Rakeln oder Schleudern, auf die Folienoberfläche aufgetragen und anschließend getrocknet wird, wobei das Lösungsmittel verdunstet. Die Dicke der trockenen Schicht liegt vorzugsweise im Bereich von etwa 0,1 bis etwa 10 µm. Geeignete Lösungsmittel sind z. B. Dimethylsulfoxid, Dimethylformamid, Tetrahydrofuran, Glykolether, wie z. B. Ethylenglykolmonomethylether und Ethylenglykolmonoethylether, Ester, wie z. B. Ethylacetat, Butylacetat und Amylacetat; Ketone, wie z. B. Methylethylketon, Cyclohexanon und Diacetonalkohol und deren Mischungen.

Die Zusammensetzung der Beschichtung auf der Grundlage des Trockengewichts soll folgende Größenanordnung haben: etwa 10 bis 60 Gew.-% an Netzmittel, 1 bis 40 Gew.-% an farbgebendem

Mittel und übliche Mengen der lichtempfindlichen Substanzen, wie sie auf diesem Gebiet bekannt sind.

Die Konzentration der Feststoffe in der Beschichtungslösung vor dem Auftragen auf das Substrat und dem Trocknen ist von dem Auftragsverfahren abhängig, im allgemeinen genügen Lösungen, die etwa 2 bis 20 Gew.-% an Feststoffen enthalten.

Für das Beschichten geeignete transparente Trägerfolien sind z. B. Folien aus Polymerisaten, die polare Gruppen enthalten, z. B. aus Polyestern, Celluloseacetat und Polyvinylchlorid. Diese Folien sind im allgemeinen etwa 20 bis 150 µm, vorzugsweise etwa 40 bis 80 µm dick. Die Haftungseigenschaften sind besonders günstig, wenn Polyesterfolien verwendet werden.

Die durch den Farbstoff gefärbten, getrockneten vorsensibilisierten Folien werden unter einem gerasterten Silberfilm-Farbauszug, der von einem farbigen Original in einer Kamera angefertigt wurde, mit ultraviolettem Licht bestrahlt. Bei einer positiv arbeitenden Prüffolie wird eine Positivvorlage genommen.

Nach dem Belichten von positiv arbeitenden Materialien werden das Lichtzersetzungsprodukt und der Farbstoff durch Behandeln mit einer schwach alkalischen Lösung, die normalerweise 0,5 bis 5 Gew.-% einer alkalischen Substanz enthält, von den Nichtbildstellen entfernt. Solche alkalischen Substanzen sind z. B. Alkalisilikate, Alkaliphosphate, Alkalicarbonate und organische Basen, wie Ethanolamine, Alkylamine und Alkylendiamine. Die entwickelten Folien werden getrocknet. Wenn sie paßgenau übereinandergelegt werden, erhält man ein Farbbild, das dem mehrfarbigen Original genau entspricht oder das eine rasche Korrektur der Silberfilme ermöglicht.

Im Anschluß an das Belichten und Entwickeln wird die Farbfolie total belichtet, um so die durch Sensibilisatorreste im Bild verursachte gelbliche Färbung zu beseitigen.

Nachfolgend wird die Erfindung anhand von Beispielen erläutert.

## Beispiel 1

Es wurde eine Beschichtungslösung der folgenden Bestandteile hergestellt:

| | |
|---|---|
| 5,1 g | Poly(methylmethacrylat/methacrylsäure) 85 : 15, |
| 0,86 g | Orasolgelb 3 GLG, |
| 6,02 g | Orasolschwarz RL, |
| 12,04 g | Naphthochinon-1,2)-diazid-(2)-5-sulfonsäureester von 2,3,4-Trihydroxy-benzophenon, |
| 6,00 g | Gafac® RE-610. |

Gafac® RE-610 ist ein Gemisch aus Phosphorsäuremono- und -diestern und hat ein spezifisches Gewicht bei 25°C von 1,10—1,12, einen Fließpunkt nach ASTM unterhalb 0°C und eine Säurezahl von 62—72.

Das Acrylpolymerisat wurde in Ethylenglykolmonomethylether gelöst. Zu dieser Lösung wurden die übrigen Bestandteile hinzugegeben. Die Lösung wurde etwa eine Stunde gerührt, gefiltert und dann auf eine 76 µm dicke biaxial verstreckte transparente Folie aus Polyethylenterephthalat aufgetragen und getrocknet. Die erhaltene schwarze Farbprüffolie war trocken und klebefrei. Ihre Durchlässigkeit betrug 11,5 auf der Hunter L-Skala. Die hier beschriebenen Versuche wurden mit einem Hunter-Lab-Farbdifferenzmeßgerät, Modell D 25D3P, durchgeführt. Belichtet wurde 20 Sekunden in einem Berkey/Ascor-Vakuumbelichtungsrahmen von 60 x 70 cm durch einen positiven Farbauszug und einen $\sqrt{2}$-Stauffer-Stufenkeil zur Ermittlung der Empfindlichkeit. Die belichtete Folie wurde mit einer wäßrigen Lösung von 9% Natriumlaurylsulfat entwickelt. Die Bildbereiche wiesen keine Anzeichen für ein Angreifen durch den Entwickler auf. Die Folie wurde mit Leitungswasser abgespült und getrocknet. Man erhielt 2 freie Stufen auf dem Stufenkeil. Anschließend wurde noch 20 Sekunden nachbelichtet. Es ergab sich ein positives schwarzes Raster-Teilfarbenbild.

Die klare Trägerfolie hatte eine Durchlässigkeit von 87 auf der Hunter L-Skala. Die Dichte (reziprok zur Durchlässigkeit) wurde durch die Wahl der Beschichtungsdicke eingestellt. Eine Durchlässigkeit von 11,5 auf der Hunter L-Skala wird subjektiv als ein sehr dichtes, tiefes Schwarz wahrgenommen.

## Beispiel 2

Es wurde nach den Angaben von Beispiel 1 gearbeitet, wobei jedoch das Netzmittel weggelassen wurde. Nach dem Trocknen der Beschichtung auf der Trägerfolie erhielt man eine Durchlässigkeit von 12 auf der Hunter L-Skala, was im wesentlichen der Durchlässigkeit der Folie aus Beispiel 1 entsprach und subjektiv von dieser nicht zu unterscheiden war. Die Folie war gleichfalls trocken und klebefrei. Um 2 freie Stufen auf dem $\sqrt{2}$-Stauffer-Stufenkeil zu erzielen, war eine Belichtung von 320 Sekunden erforderlich.

## Beispiel 3

Es wurde nach den Angaben von Beispiel 1 gearbeitet, wobei jedoch das Netzmittel weggelassen und die Durchlässigkeit der Folie auf 21 auf der Hunter L-Skala eingestellt wurde.

Um 2 freie Stufen auf der Stauffer-Skala zu erreichen, mußte 40 Sekunden belichtet werden. Die Folie sah nur noch mittel- bis dunkelgrau aus und benötigte trotzdem die doppelte Belichtungszeit der Folie aus Beispiel 1.

## Beispiel 4

Es wurde nach den Angaben von Beispiel 1 gearbeitet, wobei jedoch das Acrylsäurepolymerisat weggelassen wurde. Merkliche Unterschiede in den Ergebnissen wurden nicht festgestellt.

## Beispiel 5

Es wurde nach den Angaben von Beispiel 1 gearbeitet, jedoch wurden hier Gafac® PE-510 als Netzmittel und ein Copolymerisat aus Styrol und Maleinsäureanhydrid mit der Säurezahl 180 und dem mittleren Molekulargewicht 20 000 als Bindemittel anstelle des Acrylsäurepolymerisats genommen. Gafac® PE-510 ist gleichfalls ein Gemisch aus Phosphorsäuremono- und -diestern. Man erhielt eine trockene, klebefreie Folie. Um 2 freie Stufen aus der Stauffer-Skala zu erreichen, war eine Belichtung von 30 Sekunden erforderlich.

## Beispiel 6

Anstelle des in Beispiel 1 beschriebenen Netzmittels wurden 4 g GAFSTAT® AS-710 genommen, und das Bindemittel wurde fortgelassen. GAFSTAT® AS-710 liegt als freie Säure des komplexen Partialesters vor und hat ein spezifisches Gewicht bei 25°C von 1,05, einen Fließpunkt nach ASTM von 18°C und eine Säurezahl von 58 bis 70. Die unbelichtete Folie war trocken und klebefrei. Belichtet wurde 20 Sekunden.

## Beispiel 7

Es wurde nach den Angaben von Beispiel 6 gearbeitet, wobei jedoch die Menge an GAFSTAT® AS-710 auf 24 g erhöht wurde. Die Folie war trocken und klebefrei, jedoch wurde das Bild vom Entwickler etwas angegriffen.

## Beispiel 8

Es wurde eine Lösung der folgenden Bestandteile hergestellt:

25,5 g Acrylpolymerisat wie in Beispiel 1,
4,3 g Orasolgelb 3GLG
30,1 g Orasolschwarz RL,
18,4 g N-Diphenoxymethyl-$\varepsilon$-caprolactam,
2 g 2-(4-Ethoxy-naphth-1-yl)-4,6-bis-trichlormethyl-s-triazin.

Das Acrylpolymerisat wurde in Ethylenglykolmonomethylether gelöst. In diese Lösung wurden die übrigen Bestandteile gegeben und etwa eine Stunde gerührt. Die erhaltene Lösung wurde gefiltert und bis zu einer mit einem Gardner XL-31 Digital-Tristimulus-Colorimeter gemessenen Dichte von $13 \pm 1$ auf der L-Skala auf eine biaxial verstreckte Polyethylenterephthalatfolie aufgeschleudert. Die beschichtete Folie wurde 150 Sekunden auf einer Berkey/Ascor-Belichtungsvorrichtung belichtet und mit einem wäßrig-alkalischen Entwickler behandelt. Die Folie ließ sich nicht entwickeln, und es zeigte sich keine freie Stufe.

## Beispiel 9

Es wurde wie in Beispiel 8 gearbeitet, der Beschichtungslösung wurden jedoch 30 g Gafac® RE-610 zugesetzt. Die Belichtung war die gleiche wie in Beispiel 8 (150 Sekunden). Durch Behandlung mit einem Entwickler wurden die belichteten Stellen entfernt. Die Entwicklerresistenz war gut.

Beispiel 10

A. Zur Herstellung einer Beschichtungslösung wurden

0,604 g Orasolgelb 3GLG,
0,452 g Rhodamin FB,
1,032 g Rhodamin 6GDN extra und
4,754 g o-Chinondiazid wie in Beispiel1

in

49,00 g Ethylenglykolmonomethylether und
49,00 g Methylethylketon

gelöst. Diese Lösung wurde gefiltert und auf eine Polyesterfolie aufgetragen. Die purpurfarbene Farbprüffolie wurde 20 Sekunden belichtet. Man erhielt 2 freie Stufen auf dem Stufenkeil, nachdem die Folie mit dem gleichen Entwickler wie in Beispiel 1 entwickelt worden war. Die Entwicklerresistenz war gut.

B. Der Beschichtungslösung nach Teil A dieses Beispiels wurden 0,6 g Gafac® RE-610 zugegeben, und die Polyesterfolie wurde mit dieser Lösung beschichtet. Bei einer Belichtung von 20 Sekunden erhielt man 8 freie Keilstufen, d. h. eine Zunahme der Lichtempfindlichkeit um 6 Stufen. Die Entwicklerresistenz war etwas geringer.

Beispiel 11

A. 1,176 g Victoriareinblau FGA und
2,858 g o-Chinondiazid wie in Beispiel 1

wurden in

24,70 g Ethylenglykolmonomethylether und
74,12 g Methylethylketon

gelöst. Diese Beschichtungslösung wurde auf eine Polyesterfolie aufgetragen. Die blaugrüne Farbprüffolie wurde 20 Sekunden belichtet und dann mit dem Entwickler aus Beispiel 1 entwickelt. Es ergaben sich 2 freie Keilstufen.

B. Das Verfahren aus Teil A dieses Beispiels wurde wiederholt, jedoch wurden der Beschichtungslösung hier 0,5 g Gafac® RE-610 zugesetzt. Die beschichtete Folie zeigte 4 freie Keilstufen bei einer Belichtung von 20 Sekunden; das bedeutete eine Zunahme der Lichtempfindlichkeit um 2 Stufen. Die Entwicklerresistenz war gut.

Beispiel 12

Es wurde nach den Angaben von Beispiel 8 gearbeitet, jedoch wurden anstelle der dort verwendeten Kombination von Orthocarbonsäurederivat und Triazin 60,2 g des in Beispiel 1 angegebenen o-Chinondiazids genommen, und die Belichtung wurde auf 20 Sekunden reduziert. Die beschichtete Folie hatte gleichfalls eine Dichte von 13±1 auf der L-Skala. Nach der Behandlung mit dem in Beispiel 1 angegebenen Entwickler war der Hintergrundbereich nicht völlig sauber, und es zeigte sich keine freie Stufe.

Beispiel 13

Es wurde nach den Angaben von Beispiel 12 gearbeitet, jedoch wurde die Rezeptur jeweils durch einen anionischen komplexen Phosphatester ergänzt, um dessen Wirkungsbereich zu ermitteln. Die Mengenanteile wurden so gewählt, daß sie 10, 15, 20, 30, 40, 50 und 60 Gew.-% vom Gehalt an trockenen Feststoffen in der Gesamtbeschichtung ausmachten. Die für die Versuche genommenen Netzmittel waren:

| | |
|---|---|
| Gafac® RE-610 | Gafac® BG-510 |
| Gafac® PE-510 | Gafac® RS-410 |
| Gafac® RA-600 | Gafac® RS-710 |
| Gafac® BH-650 | Gafac® BI-750 |
| Gafac® RE-870 | |
| Gafac® RM 710 | |
| Findet® GC | |
| Findet® SB | |
| Findet® OJ-P | |

Die Kennzeichnung der Netzmittel, ihr chemischer Charakter, ihre Säurezahl, ihr spezifisches Gewicht bei 25° C und ihr Fließpunkt nach ASTM sind in der nachfolgenden Tabelle angegeben.

In allen Fällen wurde die Beschichtungsdicke so eingestellt, daß auf dem Gardner XL-31 Digital-Tristimulus-Colorimeter ein L-Wert von $13 \pm 1$ gemessen wurde. Ebenso wurde in allen Fällen auf einer Berkey/Ascor-Belichtungsvorrichtung 20 Sekunden belichtet. Entwickelt wurde mit dem in Beispiel 1 angegebenen Entwickler.

Beobachtungen über die Anzahl der nach dem Entwickeln sichtbaren freien Stufen, die Verträglichkeit der Folie und ein Angreifen des Bildes oder der Beschichtung durch den Entwickler sind in den entsprechenden Spalten der Tabelle angegeben.

Nicht alle Prozentanteile an Netzmittel wurden auch benutzt. Wenn ein bestimmter Prozentanteil ausgelassen wurde, z. B. 15%, 30%, 40% usw., enthält die zugehörige Spalte in der Tabelle einen Strich.

| Netzmittel | Typ | Säure-zahl | Spez. Gewicht bei 25° C | Fließ-punkt nach ASTM | Gehalt an Netzmittel 10% | 15% | 20% | 30% | 40% | 50% | 60% |
|---|---|---|---|---|---|---|---|---|---|---|---|
| Gafac® RE-610 | anion. (arom.) | 62—72 | 1,10—1,12 | <0° C | <1 Stufe | 1 Stufe | 2 Stufen | 4 Stufen | Schicht-haftung schlecht | abgewa-schen | — |
| Gafac® PE-510 | anion. (arom.) | 49—59 | 1,08—1,09 | 20° C | — | — | — | — | 2 Stufen | Schicht-haftung schlecht | — |
| Gafac® RA-600 | anion. (aliph.) | 100—115 | 1,06—1,08 | <0° C | — | — | — | — | 2 Stufen | — | Schicht-haftung schlecht |
| Gafac® BH-650 | anion. (aliph.) | 370—390 | 1,36—1,38¹) | <5° C | schlecht, aber gerin-ge Wirkung | — | unver-träglich | — | — | — | — |
| Gafac® BG-510 | anion. (aliph.) | 215—235 | 1,19 | 25° C | geringe Wirkung | — | Bild abge-waschen | — | — | — | — |
| Gafac® RS-410 | anion. (aliph.) | 95—115 | 1,03—1,04 | —15° C | geringe Wirkung | — | unver-träglich | — | — | — | — |
| Gafac® RS-710 | anion. (aliph.) | 58—70 | 1,04—1,06 | 18° C | geringe Wirkung <1 Stufe | — | unver-träglich | — | — | — | — |

¹) bei 50° C.

Fortsetzung

| Netzmittel | Typ | Säurezahl | Spez. Gewicht bei 25° C | Fließpunkt nach ASTM | Gehalt an Netzmittel 10% | 15% | 20% | 30% | 40% | 50% | 60% |
|---|---|---|---|---|---|---|---|---|---|---|---|
| Gafac® BI-750 | anion. (aliph.) | 250—275 | 1,26—1,28[1]) | < 0° C | < 1 Stufe | — | unverträglich | — | — | — | — |
| Gafac® RE-870 | anion. (arom.) | 80—95 | 1,10—1,20[1]) | 29° C | < 1 Stufe | 2 Stufen | 3 Stufen | — | — | — | — |
| Gafac® RM-710 | anion. (arom.) | 33—41 | 1,06—1,08 | 15° C | — | — | — | — | < 1 Stufe | 1—2 Stufen | abgewaschen |
| Findet® GC | anion. | 190 | 1,022 | nicht bekannt | — | — | nicht entwickelt | geringe Wirkung | Bild abgewaschen | — | — |
| Findet® SB | anion. | 160—175 | 1,038 | nicht bekannt | — | — | — | — | nicht entwickelt | geringe Wirkung | trüber Niederschlag |
| Findet® OJ-P | anion. | 110—125 | 1,130 | nicht bekannt | — | — | — | — | 2 Stufen | — | Bild abgewaschen |

[1]) bei 50° C.

Wie in dem ohne Netzmittel durchgeführten Beispiel 12 angemerkt, reichte die Standardbelichtung von 20 Sekunden nicht aus, um den Entwickler zum Reinigen des Hintergrundes zu befähigen oder eine freie Stufe auf der Stauffer-Skala zu ergeben. Nimmt man dagegen beispielsweise die Serie mit Gafac® RS-410, so zeigt sich, daß das Netzmittel zwar nicht so wirksam war wie z. B. Gafac® RE-610, aber dennoch eine Steigerung der effektiven Lichtempfindlichkeit gegenüber der Vergleichsrezeptur ohne Netzmittel bewirkte.

Beispiel 14

Es wurde eine Lösung der folgenden Zusammensetzung hergestellt:

| | |
|---|---|
| 2,3 g | des in Beispiel 5 angegebenen Copolymerisats, |
| 0,37 g | p-Toluolsulfonsäure, |
| 1,67 g | Calcogene-SFW unvermischt, |
| 0,68 g | Rhodamin 6 GDN Extra, |
| 0,6 g | Victoriareinblau FGA, |
| 3,46 g | eines Polykondensationsprodukts aus 1 Mol 3-Methoxy-diphenylamin-4-diazoniumsalz und 1 Mol 4,4'-Bis-methoxymethyl-diphenylether, |
| 90 g | Ethylenglykolmonomethylether. |

Eine weitere Lösung wurde durch Zusetzen von 0,5 g Gafac® RE-610 zu der angegebenen Rezeptur hergestellt. Beide Lösungen wurden auf 75 µm dicke Polyethylenterephthalatfolie aufgeschleudert, getrocknet und 30 Sekunden unter einer Vorlage belichtet. Die belichteten Proben wurden 30 Sekunden mit dem in Beispiel 1 angegebenen Entwickler entwickelt. Die erste Probe war unvollständig entwickelt und hatte einen unsauberen Bildhintergrund. Die zweite Probe war vollständig und sauer entwickelt.

Beispiel 15

Eine Lösung von

| | |
|---|---|
| 15,7 g | des in Beispiel 1 angegebenen Copolymerisats, |
| 3,9 g | Trimethylolpropantriacrylat, |
| 0,75 g | 9-Phenyl-acridin und |
| 0,5 g | Acetosol-Feuerrot in |
| 44 g | Ethylenglykolmonomethylether |

wurde hergestellt. Es wurde ferner eine Lösung sonst gleicher Zusammensetzung hergestellt, die zusätzlich 0,11 g Gafrac® RE-610 enthielt. Beide Lösungen wurden auf Polyesterfolien aufgeschleudert und getrocknet. Die erhaltenen lichtempfindlichen Folien wurden gleich lange unter einer Vorlage belichtet und dann 5 Sekunden mit 5%iger wäßriger Natriumlaurylsulfatlösung entwickelt. Die zweite Probe, die das Netzmittel enthielt, war sauber entwickelt. Die erste Probe war unvollständig entwikkelt. Bei Verlängerung der Entwicklungszeit auf 8 Sekunden wurde auch diese Probe sauber entwikkelt.

**Patentansprüche**

1. Farbprüffolie, bestehend aus einer im wesentlichen transparenten polymeren Trägerfolie, auf deren Oberfläche eine dünne Schicht eines lichtempfindlichen Gemischs haftet, das als wesentliche Bestandteile

a) ein farbgebendes Mittel,
b) als lichtempfindliche Substanz ein Iminochinondiazid, ein p-Chinondiazid, ein Kondensationsprodukt einer aromatischen Diazoniumverbindung, ein o-Chinondiazid oder ein Gemisch aus einer bei Bestrahlung Säure abspaltenden Verbindung und einer Verbindung mit mindestens einer Orthocarbonsäureestergruppe oder einer Carbonsäureamidacetalgruppe und
c) ein anionisches Netzmittel

enthält, dadurch gekennzeichnet, daß das Netzmittel das Reaktionsprodukt von 1 Mol $P_2O_5$ mit 2 bis 4,5 Mol eines Kondensationsprodukts aus mindestens 1 Mol Alkylenoxid mit 2 bis 4 C-Atomen und 1 Mol einer Verbindung mit 6 bis 150 C-Atomen ist, die ein reaktives Wasserstoffatom enthält und ein Phenol, Alkylphenol, aliphatischer Alkohol, eine Fettsäure, ein Fettamin, Fettsäureamid, Kolophoniumamin, langkettiges Sulfonsäureamid, mit langkettigen Alkylgruppen substituiertes Arylsulfonsäureamid oder hochmolekulares Mercaptan sein kann, wobei dieses Reaktionsprodukt unter im wesentlichen wasserfreien Bedingungen bei einer Temperatur zwischen Raumtemperatur und etwa 110°C hergestellt wird.

2. Farbprüffolie nach Anspruch 1, dadurch gekennzeichnet, daß das Alkylenoxid 2 C-Atome aufweist.

3. Farbprüffolie nach Anspruch 2, dadurch gekennzeichnet, daß sie als anionisches Netzmittel mindestens eine Verbindung gemäß einer der Formeln I oder II

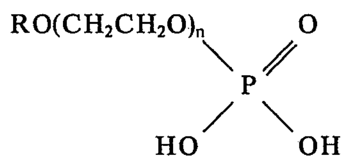

(I)

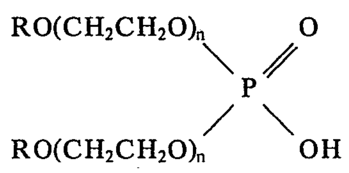

(II)

enthält, worin

R ein Alkyl- oder Alkylarylrest und
n eine Zahl von 1 bis 32 ist.

4. Farbprüffolie nach Anspruch 1, dadurch gekennzeichnet, daß das Netzmittel ein spezifisches Gewicht bei 25°C zwischen 1,00 und 1,40, einen Fließpunkt nach ASTM zwischen unterhalb 0°C und 30°C und eine Säurezahl im Bereich von 30 bis 400, berechnet als mg KOH pro g des Produkts bis zum ersten Umschlagspunkt (pH 5—5,5), aufweist.

5. Farbprüffolie nach Anspruch 4, dadurch gekennzeichnet, daß das Netzmittel ein spezifisches Gewicht bei 25°C zwischen 1,04 und 1,25 und eine Säurezahl im Bereich von 55 bis 120 aufweist.

6. Farbprüffolie nach Anspruch 1, dadurch gekennzeichnet, daß das lichtempfindliche Gemisch 10 bis 60 Gew.-% an Netzmittel enthält.

7. Farbprüffolie nach Anspruch 1, dadurch gekennzeichnet, daß die Trägerfolie eine im wesentlichen gleichmäßige Dicke im Bereich von etwa 25,4 bis 127 µm und ihre Beschichtung eine im wesentlichen gleichmäßige Dicke im Bereich von etwa 0,1 µm bis etwa 10 µm aufweisen.

8. Farbprüffolie nach Anspruch 1, dadurch gekennzeichnet, daß sie als lichtempfindliche Substanz ein o-Chinondiazid enthält.

**Claims**

1. A proof sheet with increased exposure speed consisting of a substantially transparent polymeric base sheet having a thin coating of a light sensitive composition adhered to a surface thereof, said light sensitive composition comprising as essential ingredients:

a) a colorant;
b) a light sensitive material selected from the group consisting of iminoquinone diazides, p-quinone diazides, condensation products of an aromatic diazonium compound, o-quinone diazides or mixtures of a compound which splits off an acid upon irradiation and a compound having at least one ortho carboxylic acid ester group or carboxylic acid amide acetal group; and
c) an anionic surfactant characterized in that the surfactant is the reaction product of one mole of $P_2O_5$ with 2 to 4.5 moles of a condensation product of at least one mole of alkylene oxide having 2—4 carbon atoms with one mole of a compound containing 6 to 150 carbon atoms and a reactive hydrogen atom and selected from the group consisting of phenols, alkyl phenols, aliphatic alcohols, fatty acids, fatty amines, fatty amides, rosin amines, long chain sulfonamides, long chain alkyl-substituted aryl sulfonamides, and high molecular weight mercaptans, said reaction product being prepared under substantially anhydrous conditions and at a temperature between room temperature and about 110°C.

2. The proof shett of Claim 1 where said alkylene oxide has two carbon atoms.

3. The proof sheet of Claim 2 where said anionic surfactant has the formula selected from those consisting of

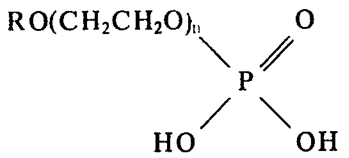

(I)

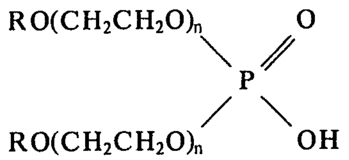

(II)

and mixtures thereof, where

R is alkyl or alkylaryl and
n is 1—32.

4. The proof sheet of Claim 1 wherein said surfactant has a specific gravity within the range of 1.00 to 1.40 at 25° C, a pour point, ASTM, within the range of below 0° C to 30° C, and an acid number within the range of 30 to 400 determined as mg of KOH per gram of product to the first inflection point (pH 5—5.5).

5. The proof sheet of Claim 4 wherein the surfactant has a specific gravity within the range of 1.04 to 1.25 at 25° C, and an acid number within the range of 55 to 120.

6. The proof sheet of Claim 1 wherein said light sensitive composition contains 10 to 60% by weight of surfactant.

7. The proof sheet of Claim 1 wherein said base sheet has a substantially uniform thickness in the range of about 25.4 o 127 µm and said coating has a substantially uniform thickness in the range of abaut 0.1 micron to about 10 microns.

8. The proof sheet of Claim 1 wherein the light sensitive material is an o-quinone diazide.

**Revendications**

1. Feuille pour épreuve de couleur, constituée d'une feuille de support polymère, essentiellement transparente, sur la surface de laquelle adhère une mince couche d'un mélange photosensible qui contient comme constituants essentiels:

a) un agent chromophore,
b) en tant que substance photosensible, un iminoquinonediazide, un p-quinonediazide, un produit de condensation d'un composé de diazonium aromatique, un o-quinonediazide ou un mélange d'un composé libérant un acide par irradiation et d'un composé ayant au moins un groupe ester d'acide orthocarbonique ou un groupe acétal de carboxamide et
c) un mouillant anionique,

caractérisée en ce que le mouillant est le produit de réaction d'une mole de $P_2O_5$ avec de 2 à 4,5 moles d'un produit de condensation d'au moins 1 mole d'oxyde d'alcoylène ayant de 2 à 4 atomes de carbone et d'une mole d'un composé ayant de 6 à 150 atomes de carbone qui contient un atome d'hydrogène réactif et peut être un phénol, un alcoylphénol, un alcool aliphatique, un acide gras, une amine grasse, un amide d'acide gras, une amine de colophane un amide d'acide sulfonique à longue chaîne, un amide d'acide arylsulfonique substitué avec des groupes alcoyle à longue chaîne ou un mercaptan de masse moléculaire élevée, ce produit de réaction étant préparé dans des conditions essentiellement anhydres à une température comprise entre la température ambiante et environ 110° C.

2. Feuille pour épreuve de couleur selon la revendication 1, caractérisée en ce que l'oxyde d'alcoylène a 2 atomes de carbone.

3. Feuille pour épreuve de couleur selon la revendication 2, caractérisée en ce que, comme mouillant anionique, elle contient au moins un composé selon l'une des formules I ou II

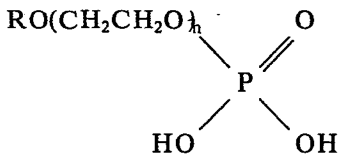

(I)

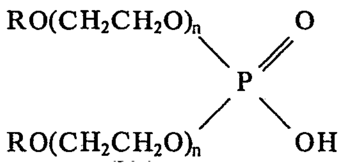

(II)

dans lesquelles

R est un groupe alcoyle ou alcoylaryle et
n est un nombre de 1 à 32.

4. Feuille pour épreuve de couleur selon la revendication 1, caractérisée en ce que le mouillant a un poids spécifique à 25° C compris entre 1,00 et 1,40, un point d'écoulement selon ASTM entre moins de 0° C et 30° C et un indice d'acide compris entre 30 et 400, calculé en mg de KOH par g du produit jusqu'au premier point de virage (pH de 5 à 5,5).

5. Feuille pour épreuve de couleur selon la revendication 4, caractérisée en ce que le mouillant a un poids spécifique à 25° C compris entre 1,04 et 1,25 et un indice d'acide compris entre 55 et 120.

6. Feuille pour épreuve de couleur selon la revendication 1, caractérisée en ce que le mélange photosensible contient de 10 à 60% en poids de mouillant.

7. Feuille pour épreuve de couleur selon la revendication 1, caractérisée en ce que la feuille de support a une épaisseur essentiellement uniforme comprise entre environ 25,4 et 127 μm et son revêtement a une épaisseur essentiellement uniforme comprise entre environ 0,1 et 10 μm.

8. Feuille pour épreuve de couleur selon la revendication 1, caractérisée en ce qu'elle contient un o-quinonediazide en tant que substance photosensible.